# EUROPEAN PATENT SPECIFICATION

(11) **EP 0 653 696 B1**
(45) Date of publication and mention of the grant of the patent: **05.03.1997**
(21) Application number: 94307386.6
(22) Date of filing: 07.10.1994
(51) Int. Cl.: G06F 3/033

(54) **Touch control of cursor position**
Berührungssteuerung der Zeigerstelle
Commande tactile de position de curseur

(30) Priority: 15.11.1993 US 151646
(43) Date of publication of application: 17.05.1995
(73) Proprietor: TEKTRONIX, INC., Wilsonville, Oregon 97070-1000 (US)
(72) Inventor: Scheck, E. Jason, Beaverton, Oregon 97007 (US)
(74) Representative: Molyneaux, Martyn William

(56) References cited:
- US-A- 4 755 811
- PATENT ABSTRACTS OF JAPAN vol. 13, no. 368 (P-919) 16 August 1989 & JP-A-01 125 612 (CANON INC.) 18 May 1989
- RESEARCH DISCLOSURE, RD312040, vol.312, no.40, 10 April 1990, HAVANT GB ANONYMOUS 'dynamic scanned image interface used with touch screen - rearranges scanned photo-images of desk top objects by touching with pointer and dragging to desired position'

## Description

### Background of the Invention

The present invention relates to cursors for waveform/graphics displays, and more particularly to touch control of cursor position for a display device using a touch sensitive display screen.

Currently cursors are positioned on displays by using buttons and knobs at a control panel. In this manner a cursor, which is a pointer to a particular point on a display identifying a feature of interest, may be moved to any point on the display screen. For waveform display devices this means that the cursor may be positioned at a particular point on a waveform so that certain information about that point, such as magnitude, or in reference to that point, such as duration, may be determined.

Touch screens are commonly used in display devices to select items from a menu displayed on the screen, or to select a region of a display for further processing. An example of further processing is a zoom function which may be implemented about a contact point on a touch screen, as disclosed in U.S. Patent No. 4,755,811 issued July 5, 1988 to Keith R. Slavin entitled "Touch Controlled Zoom of Waveform Displays" and incorporated in the VM700 Video Measurement Set manufactured by Tektronix, Inc. of Wilsonville, Oregon, United States of America.

JP-A-1125612 (Abstract) discloses a cursor at one point on the screen that can be replaced by a "touch" mark where the screen is touched, which may be an entirely different position on the screen from the cursor mark. The "touch" mark can be dragged to a desired position and when contact is removed from the screen, the "touch" mark reverts to a cursor mark.

What is desired is touch control of cursor positions so that an operator may interact intuitively with the display without the need for using buttons and knobs.

### Summary of the Invention

According to this invention there is provided a method of touch control of cursor position on a display device as claimed in claim 1 herein.

Accordingly the present invention provides a method for touch control of cursor position for a display device using a touch sensitive screen. With a cursor being displayed on a display screen, an operator touches the screen at the current position of the cursor with an appropriate pointer, such as a finger. Contact with the screen initiates a search to determine what is at the contact point on the display within a tolerance range. If the cursor is determined to be at the point of contact, then the display device enters a cursor mode so that further activities are related to the cursor. As the pointer is dragged across the screen, the position of the cursor is recalculated to remain underneath the pointer so that the cursor appears to move with the pointer. In this manner the cursor position is controlled by touching the screen. When the pointer breaks contact with the screen, further movement of the cursor in the cursor mode made be made conventionally with a knob.

The objects, advantages and other novel features of the present invention are apparent from the following detailed description when read in conjunction with the appended claims and attached drawing.

### Brief Description of the Drawing

Fig. 1 is a block diagram of a display device that uses touch control of cursor position according to the present invention.

Figs. 2A and 2B illustrate the operation of touch control of cursor position according to the present invention.

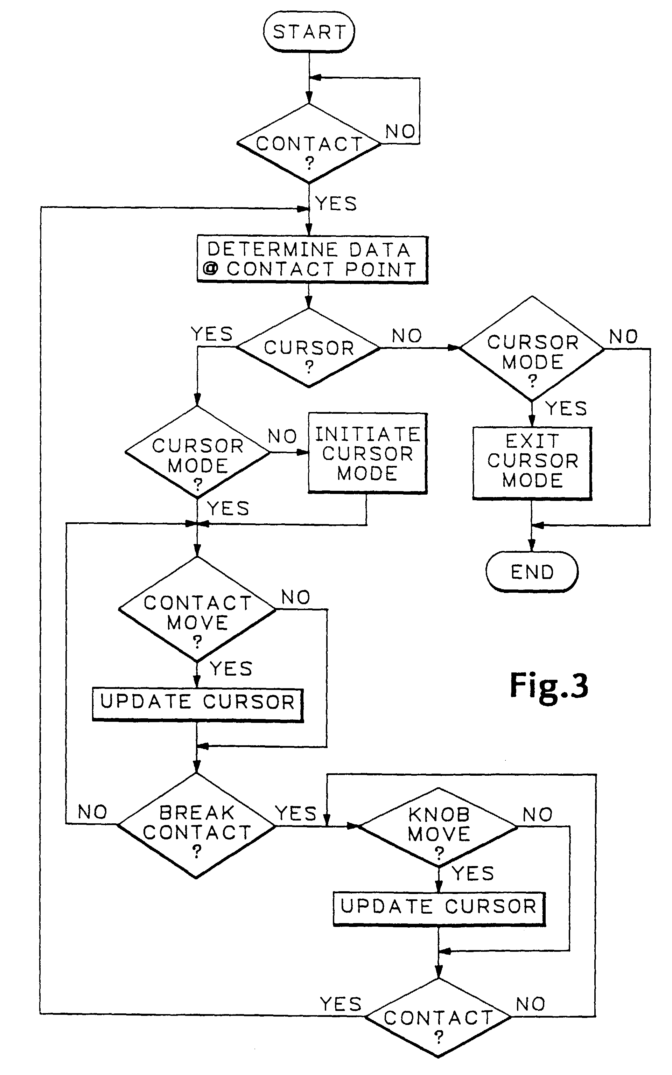

Fig. 3 is a flow chart for the touch control of cursor position according to the present invention.

### Description of the Preferred Embodiment

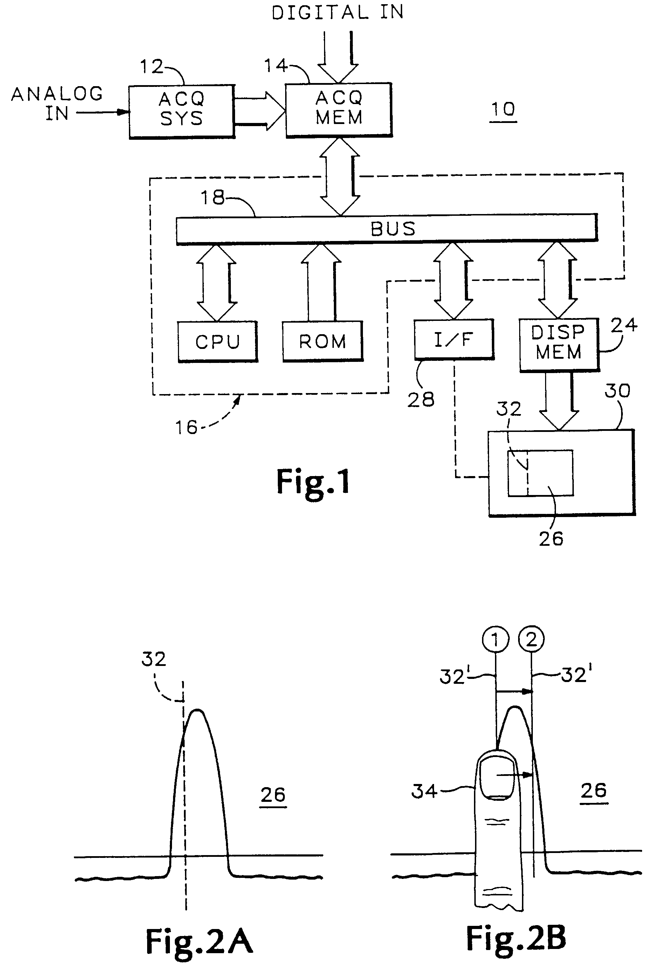

Referring now to Fig. 1 a test instrument **10** is shown of the type for acquiring and displaying waveform characteristics of an input electrical signal. However any display device, including graphics display devices, may use the touch control of cursor position as disclosed herein. All acquisition system **12** receives an analog signal and converts it to a digital signal for storage in an acquisition memory **14**. For signals that are already in digital form, such as graphics images, the signals may be input directly into the acquisition memory **14**. A display processor **16** has a bus **18** to which the acquisition memory **14** is coupled. The display processor **16** includes a processor unit **20** and a program memory **22**. The display processor **16** processes the data in the acquisition memory **14** and stores the processed data in a display memory **24**. The data from the display memory is then displayed by the display processor **16** on a screen **26**. All operator interacts with the display processor **16** via an appropriate interface **28**, such as a keyboard, mouse, touch screen on the screen **26**, controls on a front panel **30**, or the like. The display processor **16** provides a cursor **32** for the display in the form of either a vertical or horizontal line or other appropriate icon, as is well known in the art. The cursor **32** is stored with the acquired data in the display memory **24**. The initial position of the cursor **32** may be at the center of the screen **26**, or at the upper left hand corner of the screen, or other predetermined position.

To move the cursor position on the display, an operator touches the screen **26** at the current cursor position **(1)** with an appropriate pointer **34**, such as a finger shown in Fig. 2b. Contact with the screen **26** initiates a search procedure that uses the coordinates of the contact point. The display processor **16** compares the contact point with the current position of the cursor **32**, which is maintained in the display processor. If the current cursor position corresponds to the contact point, then a cursor mode is initiated. The initiation of the cursor mode may be indicated on the screen by a change in the representation of the cursor **32'** by the display processor **16**, such as changing the representation from a dotted line to a solid line or a flashing cursor icon to a steady icon.

Once the cursor mode is initiated, which includes assigning a control knob to the cursor **32'**, all further movement of the point of contact by the pointer **34** is processed by the display processor **16** as affecting the position of the cursor on the display as if it were the control knob that was being rotated. The display processor **16** updates the cursor data in the display memory **24** by rewriting it in a new position corresponding to the new contact point **(2)** of the pointer **34** on the screen **26** when the display memory is updated from the acquisition memory **14**. The cursor mode may be combined with the zoom mode, described in the aforementioned U.S. Patent No. 4,755,811, so that zoom occurs about the current contact point and the cursor is positioned closer to the point of interest as zoom occurs. Once contact is broken with the screen **26**, further movement of the cursor **32** may be controlled conventionally by the control knob.

Thus the present invention provides touch control of cursor position by determining whether a contact point on a display screen coincides with a current cursor position, and then updating the cursor position as the contact point moves across the display screen.

## Claims

1. A method of touch control of cursor **(32)** position on a display device **(30)** having a touch sensitive screen **(26)** comprising the steps of:
determining from an initial contact point **(1)** by a pointer **(34)** on the touch sensitive screen **(26)** whether a cursor **(32)** is positioned at the initial contact point; and if the cursor is positioned at said initial contact point
updating the cursor position, as the pointer moves from the initial contact point in contact across the touch sensitive screen, to correspond to an instantaneous point of contact during the movement so that the cursor appears to move on the display device with the pointer.

2. The method as recited in claim 1 wherein the determining step comprises the steps of:
determining whether the pointer is in contact with the touch sensitive screen;
identifying the contact point as the initial contact point and converting the initial contact point to a cursor position datum; and
comparing the cursor position datum with a current known cursor position to determine whether the initial position includes the cursor.

3. The method as recited in claim 2 wherein the updating step comprises the steps of:
determining whether the pointer has moved to a new contact point on the touch sensitive screen;
identifying cursor addresses for the display memory **(24)** based upon the new contact point;
writing the cursor into the cursor addresses for the new contact point when the display memory is updated; and
repeating the determining, identifying and writing steps immediately above, with the new contact point becoming the initial contact point, so long as the pointer is in contact with the touch sensitive screen.

## Patentansprüche

1. Verfahren zur Berührungssteuerung der Position des Cursors (32) bzw. der Schreibmarke auf einer Anzeigevorrichtung (30) mit einem Tast-Bildschirm (26) bzw. einem Sensor-Bildschirm, wobei das Verfahren die folgenden Schritte umfaßt:
Feststellen von einem ersten Berührungspunkt (1) durch einen Zeiger (34) auf dem Tast-Bildschirm (26), ob sich ein Cursor (32) an dem ersten Berührungspunkt befindet; und wenn sich der Cursor an dem ersten Berührungspunkt befindet,
Aktualisieren der Cursorposition, während sich der Zeiger bei gegebenem Kontakt von dem ersten Berührungspunkt über den Tast-Bildschirm bewegt, so daß die Position während der Bewegung einem momentanen Berührungspunkt entspricht, so daß es den Anschein hat, als ob ich der Cursor auf der Anzeigevorrichtung mit dem Zeiger bewegt.

2. Verfahren nach Anspruch 1, wobei der Feststellungsschritt die folgenden Schritte umfaßt:
Feststellen, ob sich der Zeiger in Kontakt mit dem Tast-Bildschirm befindet;
Kennzeichnen des Berührungspunktes als erster Berührungspunkt, und Umsetzen des ersten Berührungspunktes in eine Cursor-Positionsgröße; und
Vergleichen der Cursor-Positionsgröße mit einer aktuellen bekannten Cursor-Position, um zu bestimmen, ob die erste Position den Cursor aufweist.

3. Verfahren nach Anspruch 2, wobei der Aktualisierungsschritt die folgenden Schritte umfaßt:
Feststellen, ob sich der Zeiger zu einem neuen Berührungspunkt auf dem Tast-Bildschirm bewegt hat;
Kennzeichnen der Cursor-Adressen für den Anzeigespeicher (24) auf der Basis eines neuen Berührungspunktes;
Schreiben des Cursors in die Cursor-Adressen in bezug auf den neuen Berührungspunkt, wenn der Anzeigespeicher aktualisiert wird; und
Wiederholen der unmittelbar vorstehenden Schritte des Feststellens, Kennzeichnens und Schreibens, wobei der neue Berührungspunkt zu dem ersten Berührungspunkt wird, bis sich der Zeiger in Kontakt mit dem Tast-Bildschirm befindet.

## Revendications

1. Procédé de commande tactile de la position d'un curseur (32) sur un dispositif d'affichage (30) comportant un écran tactile (26), comprenant les étapes qui consistent à :
déterminer à partir d'un point de contact initial (1) par un index (34) sur l'écran tactile (26) si le curseur (32) est positionné au point de contact initial ; et,
si le curseur est positionné audit point de contact initial, mettre à jour la position du curseur, quand l'index se déplace à partir du point de contact initial en contact sur l'écran tactile, pour la faire correspondre à un point de contact instantané pendant le déplacement pour que le curseur paraisse se déplacer sur le dispositif d'affichage avec l'index.

2. Procédé selon la revendication 1, dans lequel l'étape de détermination comprend les étapes consistant à :
déterminer si l'index est en contact avec l'écran tactile ;
identifier le point de contact comme point de contact initial et convertir le point de contact initial en une donnée de position de curseur ; et,
comparer la donnée de position de curseur à une position de curseur alors connue pour déterminer si la position initiale comprend le curseur.

3. Procédé selon la revendication 2, dans lequel l'étape de mise à jour comprend les étapes consistant à :
déterminer si l'index s'est déplacé jusqu'à un nouveau point de contact sur l'écran tactile ;
identifier des adresses de curseur pour la mémoire d'affichage (24) selon le nouveau point de contact ;
écrire le curseur aux adresses de curseur pour le nouveau point de contact quand la mémoire d'affichage est mise à jour ; et,
répéter les étapes de détermination, d'identification et d'écrire juste ci-dessus, avec le nouveau point de contact devenant le point de contact initial, tant que l'index est en contact avec l'écran tactile.
